# EUROPEAN PATENT APPLICATION

(11) **EP 2 264 466 A1**
(43) Date of publication of application: **22.12.2010**
(21) Application number: 09730220.2
(22) Date of filing: 07.04.2009
(51) Int. Cl.: G01N 35/08, B01J 19/00, B81B 1/00, B81C 3/00, G01N 37/00

(54) **MICROCHIP AND METHOD FOR MANUFACTURING MICROCHIP**

(30) Priority: 11.04.2008 JP 2008103174
(71) Applicant: Konica Minolta Opto, Inc., Hachioji-shi Tokyo 192-8505 (JP)
(72) Inventor: HIRAYAMA, Hiroshi, Hachioji-shi Tokyo 192-8505 (JP)
(74) Representative: Henkel, Feiler & Hänzel
(86) International application number: PCT/JP2009/057110
(87) International publication number: WO 2009/125757

(57) **Abstract**

A microchip has a resin substrate, which is provided with a first surface whereupon a channel groove is formed and a second surface on the opposite side to the first surface, and the microchip also has a resin film bonded on the first surface. A projection area is larger than the area of the first surface of the resin substrate when the resin substrate is viewed from a direction orthogonally intersecting with the first surface. Thus, warpage of the microchip can be suppressed at the time of thermally bonding the resin substrate and the resin film by a roller.

## Description

### TECHNICAL FIELD

The present invention relates to a microchip having a flow path and a method for preparing the same.

### BACKGROUND TECHNOLOGY

There has been practically used a device, called a microchip or µTAS (Micro Total Analysis Systems), which carries out a chemical reaction, separation, or analysis of a liquid sample such as a nucleic acid, protein, and blood, on a minute space, which is created in such a way that minute flow path grooves are formed on a silicon or glass substrate using the micromachining technology, and then, a flow path or a circuit is formed by bonding a tabular seal member to the aforesaid substrate. The merit of such a microchip may be to realize a small, portable and inexpensive system, in which an amount of sample or reagent to be used or an amount of emission of waste liquid are reduced.

In addition, from a demand for a reduction in a preparing cost, it has also been studied that the microchip is manufactured using a resin substrate and a sealing member for a microchip.

As a method for bonding a resin substrate to a resin sealing member, there have been known methods such as a method for utilizing an adhesive, a method for bonding them by melting a resin surface with a solvent, a method for utilizing an ultrasonic fusion-bonding, a method for utilizing a laser fusion-bonding, and a method for utilizing a thermal fusion-bonding. However, in case of forming a flow path by bonding a tabular seal member, if a slight strain or warp was present on the shape of the substrate or the sealing member, it became difficult to form a uniform flow path, which tended to be a problem for the microanalysis chip in which a very high accuracy was required.

Then, there has been studied a microchip, in which a resin film is bonded to a resin substrate on which minute flow path grooves are formed. The aforesaid microchip is manufactured with a resin substrate, on which surface flow path grooves were formed, as well as through-holes (being a chemical reagent introduction and discharge hole; it may also be referred to as a well) arranged at an end of the flow path groove were formed, and a resin film bonded to the surface of the resin substrate.

The method for bonding the resin substrate to the resin film includes, similarly to the case of the microanalysis chip comprising the above resin substrate and tabular seal member, a method for utilizing an adhesive, a method for bonding them by melting a resin surface with a solvent, a method for utilizing an ultrasonic fusion-bonding, a method for utilizing a laser fusion-bonding, and a method for utilizing a thermal fusion-bonding using a tabular or a roll-shape pressure device. Among these methods, since the thermal fusion-bonding can be carried out with a low cost, the method for utilizing the thermal fusion-bonding is a suitable bonding method for a mass-production.

As the microchip of such a type, having been proposed is a microchip, in which an acrylic resin film such as polymethyl methacrylate is thermally fusion-bonded to an acrylic resin substrate (for example, Patent Document 1).

### PRIOR ART

### PATENT DOCUMENT

Patent Document 1: Japanese Patent Application Publication 1: No. 2000-310613

### SUMMARY OF THE INVENTION

### ISSUES TO BE SOLEVED BY THE INVENTION

In a similar method to the method described in the above patent document, a resin substrate and a resin film were thermally bonded by a heat press machine. After the bonding, when a microchip was observed, it was found that air bubbles were mixed in the adjacent bonding surface of a minute flow path.

In order to prevent the mixing-in of air bubbles, studied was a heat bonding of the resin substrate to the resin film using a heat laminating machine. At this time, the resin film was matched to the surface of the resin substrate on which minute flow paths were formed, and the resin substrate having the film thereon was placed on a plane board, and then, the resin substrate was heat bonded to the resin film using a heat roller. In such the case, after the bonding, it was found that a warp, running along the circumferential direction of the roller, was generated on the microchip.

As a result of the study by the inventors, it was found that temperature and pressure affecting on the resin substrate and the resin film became primary factors in the warp of the bonded microchip.

First of all, the primary factor relating to the temperature is described below. In case where one or both of the resin substrate side and the resin film side are heated, if heating temperature differs, a temperature gradient is generated within a microchip, and then heat strain is caused to result in a warp of the microchip. In this case, even if the microchip is cooled, the warp remains in most cases. Even if the heating temperatures on the both sides are made equal, since there exist difference in the coefficient of thermal expansion, the thermal conductivity, or the thermal capacity between the resin substrate and the resin film, it is difficult to uniformly heat the resin substrate and the resin film, and then, the above differences cause the warp of the microchip. Further, there may exist a case where the resin substrate and the resin film has to be bonded by heating mainly the resin film side to retain a shape of a minute flow path which was precisely transferred, thereby it becomes difficult to restrain the generation of the warp.

Next, the primary factor relating to the pressure is described below. In thermal bonding, the pressure is applied to the resin substrate and the resin film to sustain, close contact and defoam them, and in this case the pressure distribution within the microchip causes the warp. The most idealistic case is that the pressure is uniformly applied from both the resin substrate and the resin film sides. Since the pressure changes depending also on a modulus of elasticity, bending strength, or surface hardness of the resin substrate and the resin film, it is of course best that materials and sizes of the resin substrate and the resin film can be appropriately selected, but, since materials and sizes suitable for the analysis using the microchip and for the bonding are not necessarily agree with each other, it is difficult to uniformly apply pressure, namely, to restrain the warp.

The method for applying pressure includes; (1) a method in which rollers are rotated while holding the resin substrate and the resin film from the both sides thereofbetween the rollers, (2) a method in which the resin film side is made as a roller and the resin substrate side is made as a plane board to hold the resin substrate, and the roller is rotated while pressing the plane board, and (3) a pressing method in which the resin substrate 10 and the resin film 20 are pressed by parallel boards from the both sides.

The method (1) for rotating rollers while holding between the rollers is a very effective method for a bonding between resin films with each other, but since the resin substrate of the present invention is an injection-molded article, the article is unable to be successively supplied like the resin film. Therefore, it is difficult to set the resin substrate and the resin film between two rollers and bond them without misaligning two axes which become pressure centers of the two rollers. If the resin substrate and the resin film shift with respect to each other, wrinkles are generated and air bubbles are mixed in. And if central axes of the two rollers are misaligned, the pressure is not uniformly applied, to result in the generation of the warp of the resin substrate.

The method (2), in which a roller is rotated while pressing on a plane surface with the roller, differs from the method (1), and can readily hold the resin substrate on the plane board. However, while the roller makes a linear contact with the resin film, the plane board makes a plane contact with the resin substrate, and therefore, the pressure is not uniformly applied to cause a warp of the resin substrate.

The method (3) has such a merit that it is easy to apply uniform pressure. However, it is impossible for the method (3) to make a bonding while squeezing the resin film to draw out air bubbles like the methods (1) and (2) which use rollers, and since the bonding surface of the resin substrate and the surface of the resin film which is bonded are directly glued together, air bubbles are easily mixed in. In addition to that, a considerable degree of pressure is required to remove the air bubbles, and as a result, the shapes of minute flow paths which were precisely transferred can not be maintained. Further, there is also a problem that, since the plane board is close contacted with the resin film or the resin substrate, the plane board is glued on so strongly that the microchip may be deformed when the microchip is peeled off from the plane board, if the microchip is not sufficiently cooled.

As described above, it was difficult to prepare an excellent microchip having no warp even if any one of the methods (1) to (3) was selected.

The warp of the microchip has the following three problems: The first problem is that the quality of external appearance is poor. The second problem is that, in case of setting the microchip on an analysis equipment, the positioning accuracy decreases, which leads to decrease in the analytical precision. In case of the microchip, since detection is generally carried out at a minute flow path of several tens of microns, the positioning is important when the microchip is set on the analysis equipment.

The third problem is that random variation in thermal conduction is caused and the thermal conduction decreases, both of which leads to decrease in the analytical precision. There is a case where the whole microchip is heated and cooled when a chemical reaction is carried out. To carrying out effectively the heating and cooling, it is desirable that the microchip is closely contacted to a source of heating or cooling. In particular, in case of carrying out an analysis where a high voltage is applied like an electrophoresis, the microchip is required to be cooled by a water-cooling jacket or a Peltier device so that liquid in minute flow paths or an object for analysis does not boil by the heating.

The tolerance of warp of the microchip is as follows: The tolerance of warp is not described unconditionally, since it depends on the size of the microchip or conditions in which the microchip is used, but when an warp angle is within 5 mm radian, the microchip is a usable level provided that the microchip is firmly held down, and when it is within 2 mm radian, the microchip is a usable level without the microchip being held down. Naturally, it is desirable that the microchip has no warp.

When, in order to restrain the warp, using a jig having claw portions for fixing the resin substrate, the resin substrate and the resin film were thermally fusion-bonded while four corners of the resin substrate being firmly held down with the claw portions during thermal bonding of the resin substrate and the resin film by a roller, the generation of the warp was retrained. However, there caused a problem that the resin film was not bonded or the bonding strength of the resin film was insufficient at a surrounding area including the four corners of the resin substrate which was firmly held down with the claw portions.

The present invention is to solve the above problems, and the purpose is to provide a microchip and a method for preparing the same, which can restrain a warp of the microchip, when a resin substrate and a resin film are thermally bonded by a roller.

### MEASURES TO SOLVE THE ISSUES

To solve the above issues, the invention described in Claim 1 is a microchip including: a resin substrate provided with a first surface on which flow path grooves are formed and a second surface which is located on an opposite side of the first surface; and a resin film bonded to the first surface; wherein a projected area of the resin substrate, when viewed from a direction perpendicular to the first surface, is larger than the area of the first surface of the resin substrate.

The invention described in Claim 2 is a microchip described in Claim 1, wherein the resin substrate has a shape of a frustum in which the area of the second surface is larger than the area of the first surface.

The invention described in Claim 3 is a microchip described in Claim 1, further including; a protruding part, which is arranged at a sidewall of the resin substrate between the first and the second surfaces and protrudes outward from the periphery of the first surface; and the protruding part is arranged at a position of a second surface side of the sidewall.

The invention described in Claim 4 is a microchip described in Claim 1, further including; a protruding part, which is arranged at the sidewall of the resin substrate at between the first and the second surfaces and protruded outward from the periphery of the first surface; and the protruding part is arranged at an intermediate location between the first and the second surfaces of the sidewall.

The invention described in Claim 5 is a microchip described in Claim 3 or 4, wherein a board thickness of the protruding part is 0.5 mm or more, and is thinner than the board thickness of the resin substrate.

The invention described in Claim 6 is a microchip described in any one of Claims 3 to 5, wherein the protruding part is foamed via an injection molding in an integrated fashion with a body of the resin substrate.

The invention described in Claim 7 is a method for manufacturing a microchip having a resin substrate provided with a first surface on which flow path grooves are formed and a second surface which is located on an opposite side of the first surface and having a shape in which a projected area when viewed from a direction perpendicular to the first surface is larger than an area of the first surface, and a resin film bonded to the first surface, wherein the method including the steps of: fixing a sidewall of the resin substrate using a jig; and bonding a resin film on a surface of the resin substrate which is fixed with the above jig.

The invention described in Claim 8 is a method for preparing a microchip described in Claim 7, wherein the resin substrate has a protruding part, which is arranged at a sidewall of the resin substrate at between the first and the second surfaces and protrudes outward from the periphery of the first surface; and the protruding part is fixed with the jig at the fixing step.

The invention described in Claim 9 is a method for preparing a microchip described in Claim 7 or 8, wherein, the jig is arranged so as not to be protruded in the direction perpendicular to the first surface than an imaginary plane which is an extension of the first surface, at the fixing step.

### EFFECT OF THE INVENTION

According to the invention descried in Claim 1, since the projected area of the resin substrate is larger than the area of the first surface which is the side of the resin substrate where the resin film is bonded, the resin substrate protrudes outward from the first surface. When the resin substrate and the resin film are thermally bonded, since the protruding part is firmly held down with a jig, the warp of the microchip can be restrained. Further, when the resin substrate and the resin film are thermally bonded, since one surface of the resin substrate is not firmly held down with the jig, it becomes possible to bond the resin film to one surface of the resin substrate with a sufficient strength.

According to the invention described in Claim 2, since the resin substrate has a shape of a frustum in which the area of the above second surface is larger than the area of the above first surface which is the side where the resin film is bonded, the sidewall of the resin substrate is inclined from the first surface toward the second surface of the resin substrate. When the resin substrate and the resin film are thermally bonded by a roller, since the inclined sidewall is firmly held down with the jig, the warp of the microchip can be restrained. In addition, since the inclined sidewall and the inclined part of the jig make a close contact with each other when the jig is simply brought closer to the sidewall, the sidewall is easily firmly held down with the jig. Further, when the resin substrate and the resin film are thermally bonded, since the first surface of the resin substrate is not firmly held down with the jig, it becomes possible to bond the resin film to the first surface of the resin substrate with a sufficient strength.

According to the invention described in Claim 3, when the resin substrate and the resin film are thermally bonded, the protruding part is firmly held down with the jig. With this, the warp of the microchip can be restrained. Further, since the first surface of the resin substrate which is the side where the resin film is bonded is not firmly held down with the jig, it becomes possible to bond the resin film to the first surfaces of the resin substrate with a sufficient strength. Further, since the protruding part is arranged at a position of the second surface side of the resin substrate of the sidewall of the resin substrate, the resin substrate can be simply formed by forming one of the surface sides of the resin substrate larger than the other surface side.

According to the invention described in Claim 4, when the resin substrate and the resin film are thermally bonded, the protruding part is firmly held down with the jig. With this, the warp of the microchip can be restrained. Further, since the first surface of the resin substrate which is the side where the resin film is bonded is not firmly held down with the jig, it becomes possible to bond the resin film to the first surfaces of the resin substrate with a sufficient strength. Further, since the protruding part is arranged at an intermediate location between the first and the second surfaces of the resin substrate of the sidewall of the resin substrate, an adjacent part of one of the surfaces of the resin substrate can be firmly held down with the jig, and thereby it becomes possible to decrease the degree of warp of the microchip.

According to the invention described in Claim 5, since the board thickness of the protruding part is 0.5 mm or more, it has sufficient rigidity, and thereby, during thermal bonding process, the protruding part can sufficiently oppose the warping force of the microchip. Further, since the board thickness of the protruding part is thinner than the board thickness of the resin substrate, during thermal bonding process by a roller, the roller does not interfere with the protruding part or the jig which restrains the protruding part. With this, it becomes possible to bond the resin film to one surface of the resin substrate with a sufficient strength.

According to the invention described in Claim 6, since the protruding part is formed in an integrated fashion with the body of the resin substrate, the protruding part can be manufactured at low cost.

According to the invention described in Claim 7, since the projected area of the resin substrate is larger than the area of the first surface of the resin substrate which is the side where the resin film is bonded, the resin substrate protrudes outward from the first surface. When the resin substrate and the resin film are thermally bonded by a roller, the sidewall of the resin substrate, being a protruding part, is fixed with a jig, and the resin film is bonded to the surface of the resin substrate with the sidewall being fixed, and thereby the microclip can be prepared with the warp of the microchip being restrained. Further, when the resin substrate and the resin film are thermally bonded, since one of the surfaces of the resin substrate is not firmly held down with the jig, it becomes possible to bond the resin film to one of the surfaces of the resin substrate with a sufficient strength.

According to the invention described in Claim 8, when the resin substrate and the resin film are thermally bonded, the protruding part is fixed with a jig, and the resin film is bonded to the surface of the resin substrate with the protruding part being fixed, and thereby the microchip can be prepared with the warp of the microchip being restrained. Further, since the first surface of the resin substrate which is the side where the resin film is bonded is not firmly held down with the jig, it becomes possible to bond the resin film to the first surface of the resin substrate with a sufficient strength.

According to the invention described in Claim 9, since a jig is further arranged so as not to be protruded in the direction perpendicular to the first surface from an imaginary plane which is an extension of the first surface of the above resin substrate, a roller does not interfere with the jig when thermal bonding by the roller is carried out. With this, it becomes possible to bond the resin film to the first surface of the resin substrate with a sufficient strength.

### BRIEF DESCRIPTION OF THE DRAWINGS

Fig. 1a is a plan of the microchip relating to the present invention, Fig. 1b is a cross-sectional view of Fig. 1 a along the line IB-IB, Fig. 1c is an enlarged cross-sectional view of a minute flow path, and Fig. 1d is an explanatory drawing of a method for preparing the microchip.
Fig. 2a is a cross-sectional view of the microchip relating to the other embodiment of the present invention, and Fig. 2b is an explanatory drawing of a method for preparing the microchip.
Fig. 3a is a cross-sectional view of the microchip relating to further other embodiment of the present invention, and Fig. 3b is an explanatory drawing of a method for preparing the microchip.
Fig. 4 is a table showing conditions for preparing the microchip and evaluation results.

### MODE FOR CARRYING OUT THE INVENTION

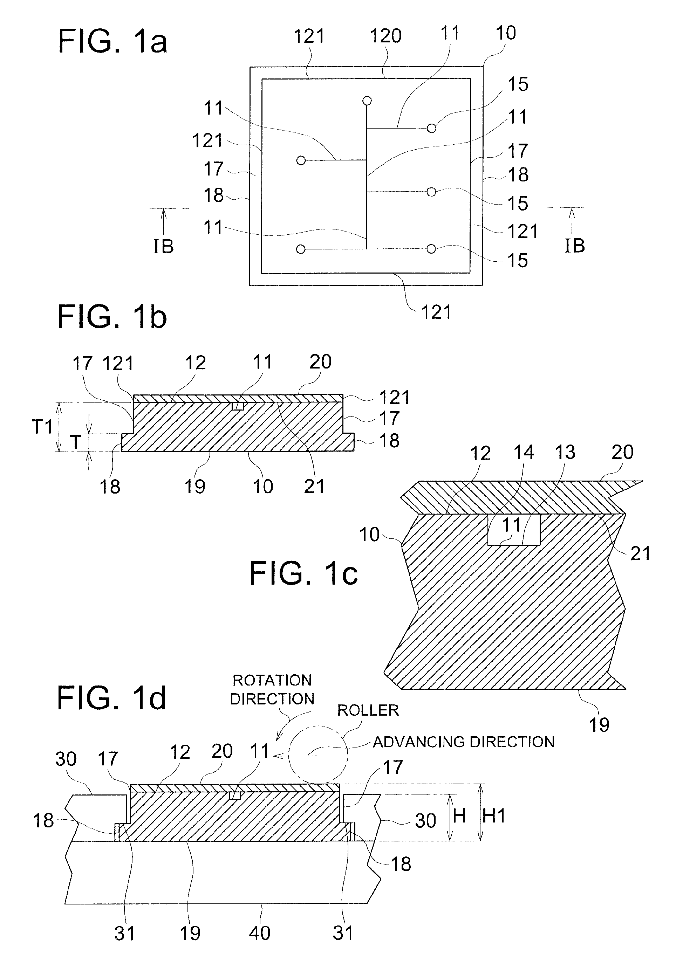

The microchip relating to the embodiment of the present invention and a method for preparing the same will be described with reference to Fig. 1. Fig. 1a is a plan of the microchip relating to the present invention, Fig. 1b is a cross-sectional view of Fig. 1a along the line IB-IB, and Fig. 1c is an enlarged cross-sectional view of a minute flow path.

### (Constitution of Microchip)

As shown in Figs. 1a and 1b, a flow path groove 11 is formed on one surface 12 of a resin substrate 10. A resin film 20 is bonded to a first surface 12 on which the flow path groove 11 of the resin substrate 10 is formed. By bonding the resin film 20 to the resin substrate 10, the microchip is prepared. A surface in which one surface 12 of the resin substrate 10 was bonded to a lower surface 21 corresponds to a bonding surface of the microchip.

As shown in Figs. 1b and 1c, a minute flow path is constituted with an undersurface 13 and a surface of wall 14 of the flow path groove 11 and the lower surface 21 of the resin film 20.

A through-hole 15 is formed in order to inject a liquid sample (being an analysis sample, a solvent sample, or a reagent) into the minute flow path in the microchip. This hole is also referred to as a well. In general, the minute flow path is formed in such a way that the through-hole 15 is formed at the end of or along the flow path groove 11 of resin substrate 10, and then, the resin film 20 is pasted to the first surface 12 of the resin substrate 10. The liquid sample is introduced from a second surface 19 opposite to the first surface 12 on which the resin film 20 was pasted.

The resin is used for the resin substrate 10 and the resin film 20. As the resin used, there are listed as its conditions are properties such as excellent formability (being transferability, or releasability), high transparency, and low autofluorescence at UV light or visible light, but are not particularly limited to them. The preferable examples include polycarbonate, polymethyl methacrylate, polystyrene, polyacrylonitrile, polyvinyl chloride, polyethylene terephthalate, Nylon 6, Nylon 66, polyvinyl acetate, polyvinylidene chloride, polypropylene, polyisoprene, polyethylene, polydimethylsiloxane, and cyclic polyolefine. Particularly preferable are polymethyl methacrylate, and cyclic polyolefine. For the resin substrate 10 and the resin film 20, the same material may be used, or different materials may be used.

The shape of the resin substrate 10 may be any shape as long as it is easy to handle or analyze as the microchip. For example, the size is preferably about 10 mm square to about 200 mm square, and more preferably 10 mm square to 100 mm square. The shape of the resin substrate 10 and resin film 20 may be adapted to an analytical method or an analysis equipment, and is preferably a shape such as a square, a rectangle or a circle.

The shape of the minute flow path is preferably within the range of 10 µm to 200 µm in both width and depth, in consideration that the amount of analysis sample or reagent to be used can be made small as well as preparing accuracy, transferability, or releasability of a forming die, but is not particularly limited to them. The aspect ratio (being a ratio of a depth of groove to a width of groove) is preferably about 0.1 to about 3, and more preferably about 0.2 to about 2. The width and the depth of the minute flow path may be determined according to the use of the microchip. Although the cross sectional shape of the minute flow path shown in Fig. 1 is a rectangle to make the explanation simple, the above shape is just one example of the minute flow path, and the shape may be a curved surface.

The board thickness of the resin substrate 10, on which minute flow paths were formed, is preferably about 0.2 mm to about 5 mm, and more preferably 0.5 mm to 2 mm in consideration of formability of the substrate. The board thickness of the resin film 20 (being a sheet-like member) functioning as a cover to cover the minute flow paths is preferably 30 µm to 300 µm, and more preferably 50 µm to 200 µm.

Next, a constitution to restrain the warp of the microchip will be described with reference to Fig. 1.

The projected area of the resin substrate 10 when viewed from a direction perpendicular to the first surface 12 of the resin substrate 10, to which the resin film 20 was bonded, is larger than the area of the first surface 12 of the resin substrate 10.

The sentence "the first surface 12 of the resin substrate 10 to which the resin film 20 was bonded" means the surface 12 which is a side of the resin substrate 10 to which the resin film 20 is bonded. The phrase "a direction perpendicular to the first surface 12 of the resin substrate 10" means an upward direction in Fig. 1b. Further, the term "a projected area of the resin substrate 10" means a projected area when viewed from a direction perpendicular to the first surface 12 of the resin substrate 10.

The present invention is **characterized in that** the projected area of the resin substrate 10 is larger than the area of the first surface 12 of the resin substrate 10. To realize it, there are possible constitutions such that the sidewall 17 constituting the outer peripheral of the resin substrate 10 protrudes outward over all around the resin substrate 10, or a part of the sidewall 17 protrudes outward from a periphery 121 of the first surface 12 of the resin substrate 10, or the whole or a part of the sidewall 17 constituting a length in the board thickness direction of the resin substrate 10 protrudes outward from a periphery 121 of the first surface 12 of the resin substrate 10.

Shown in Figs. 1 a and 1b is a constitution, in which the whole of the sidewall 17 constituting the outer peripheral of the resin substrate 10 protrudes outward from the periphery 121 of the first surfaces 12 of the resin substrate 10, and at the same time, a part of the sidewall 17 constituting a length in the board thickness direction of the resin substrate 10 protrudes outward from the periphery 121 of the first surface 12 of the resin substrate 10.

A part protruding outward from the periphery 121 of the first surface 12 of the resin substrate 10 is referred to as a protruding part 18. The protruding part 18 is disposed at a position of the second surface 19 side of the resin substrate 10 of the sidewall 17 of the resin substrate 10.

In Figs. 1a and 1b, the protruding parts 18 are disposed over the whole sidewalls 17 constituting the outer peripheral of the resin substrate 10, but may be disposed at a part of the sidewalls 17. For example, when the resin film 20 is bonded to the resin substrate 10 by a roller (not illustrated), a pair of protruding parts 18 may be disposed at both sides from and to which the roller advances so that they faces each other. Further, a pair of protruding parts 18 may also be disposed along the advancing direction of the roller as well as facing each other.

A board thickness T of the protruding part 18 is 0.5 mm or more, and is thinner than a board thickness T1 of the resin substrate 10. Since the board thickness T of the resin substrate 10 was made 0.5 mm or more, rigidity of the protruding part 18 becomes high, and thereby, during thermal bonding process between the resin substrate 10 and the resin film 20, the protruding part 18 can sufficiently oppose the warping force of the microchip. Further, since the board thickness T of the protruding part 18 was made thinner than the board thickness T1 of the resin substrate 10, during thermal bonding process between the resin substrate 10 and the resin film 20, a jig 30 can hold down the protruding part 18 at the lower position than the height of the resin film 20. The length of the protruding part 18 protruding outward from the periphery 121 of the first surface 12 is a minimum necessary length for holding down the protruding part 18 with the jig 30.

Next, the method for preparing the microchip will be described with reference to Fig. 1d. The method for preparing the µ chip is such that each of the resin substrate 10 and the resin film 20 is preparing, and then the resin substrate 10 and the resin film 20 are thermally bonded to each other by a roller (not illustrated).

The microchip is preparing based on the following steps: In the step 1, the resin substrate 10 is formed by an injection molding machine into the prescribed size and thickness. The protruding part 18 is formed in an integrated fashion with the body of the resin substrate 10. During molding thereof, the flow path grooves 11 and the through-holes 15 are formed simultaneously. The flow path grooves 11 and the through-holes 15 may be formed after the injection molding process. In the step 2, the resin film 20 is prepared by cutting a film having the prescribed thickness into the prescribed size.

In the step 3, the resin substrate 10 is placed on a stage 40 with the second surface 19 of the resin substrate 10 down. The resin film 20 is superposed on the whole of one surface of the resin substrate 10 in which the flow path grooves 11 are formed, that is the first surface 12. In the step 4, each of a pair of protruding parts 18 facing each other is firmly held down by the jig 30 (being a fixing step). As the jig 30, used is a jig which is formed in a square-like framework by cutting a hole in the center of a stainless steel board, the size of which hole is greater than that of the first surface 12 of the resin substrate 10. The lower side of the jig 30 is deeply cut out so as not to interfere with the protruding part 18. Close contacting parts 31, which are the ceilings of the cut out concavo portions, are made close contact with a pair of protruding parts 18.

A pair of protruding parts 18, which are firmly held down by the jig 30, may be a pair of protruding parts 18, each of which is disposed at each of both sides from and to which the roller advances so that they faces each other, or may be a pair of protruding parts 18, each of which is disposed along the advancing direction of the roller so that they faces each other.

The thickness of the jig 30 is made smaller than the total thickness of the resin substrate 10 and the resin film 20 so that the roller does not interfere with the jig 30. The jig 30 which was disposed at lower position than the position of the resin film 20 which is bonded to the first surface 12 of the resin substrate 10 is shown in Fig. 1d. In the step 5, the resin film 20 is thermally bonded to the resin substrate 10 by a roller (a bonding step).

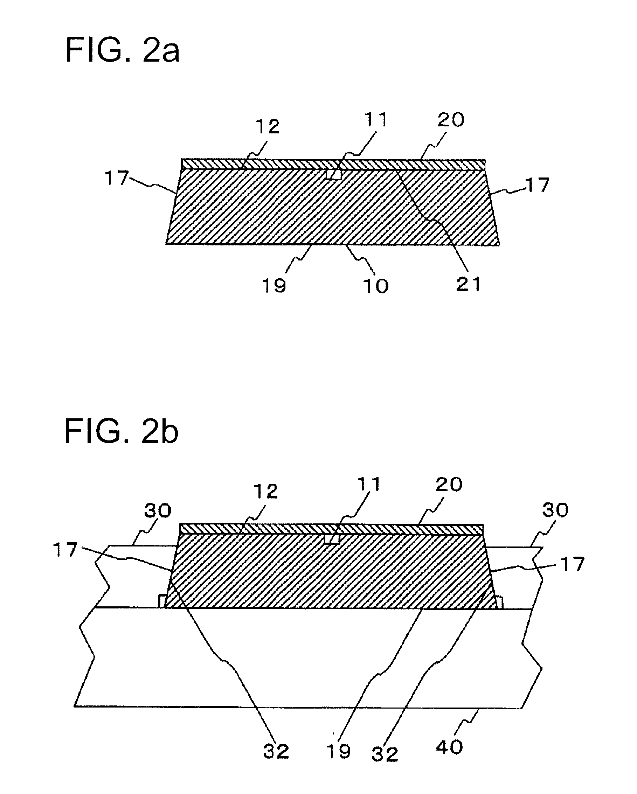

Next, the microchip relating to the other embodiment of the invention will be described with reference to Fig. 2. Fig. 2a is a cross-sectional drawing of the microchip which was cut by a surface perpendicular to the first surface of the microchip, and Fig. 2b is a drawing showing a method for preparing the microchip.

The resin substrate 10, having a shape of a frustum in which the area of the second surface 19 is larger than that of the first surface 12, is shown in Fig. 2a. The sidewall 17 of the resin substrate 10 is inclined outward from the first surface 12 toward the second surface 19. The shape of the resin substrate 10 is not limited to a frustum of square pyramid as shown in Fig. 2a, but may be a frustum of a triangular pyramid, a frustum of a multi-sided pyramid or a frustum of a cone. Further, it is not necessary for each of four sidewalls 17 of the resin substrate 10 being inclined outward, but a pair of sidewalls 17 facing each other may be inclined outward. In addition, the above-described protruding part 18 may be disposed at the inclined sidewall 17.

Next, a method for preparing the microchip shown in Fig. 2a will be described with reference to Fig. 2b. The method for preparing the microchip shown in Fig. 2a differs from the above-mentioned method for preparing the microchip shown in Fig. 1 in the step 4, but the other steps (that is, the steps 1 to 3 and 5) is basically the same. In the following, only the step 4 will be described and descriptions on the other steps will be omitted.

In the step 4 of the method for preparing the microchip shown in Fig. 2a, each of a pair of sidewalls 17 facing each other is firmly held down by the jig 30 (being a fixing step). As the jig 30, used is a jig which is formed in a square-like framework by cutting a hole in the center of a stainless steel board, the size of which is greater than that of the four sidewalls 17 of the resin substrate 10. The inside surfaces of the jig 30 having a framework shape are inclined to fit the sidewall 17, and close contacting parts 32, which are the inside surfaces of the jig, are made close contact with a pair of protruding parts 18.

A pair of sidewalls 17, which are firmly held down by the jig 30, may be a pair of sidewalls 17, each of which is disposed at each of both sides from and to which the roller advances, or may be a pair of sidewalls 17, each of which is disposed along the advancing direction of the roller.

The thickness of the jig 30 is made smaller than the total thickness of the resin substrate 10 and the resin film 20 so that the roller does not interfere with the jig 30. The jig 30 which was disposed at lower position than the position of the resin film 20 which is bonded to the first surface 12 of the resin substrate 10 is shown in Fig. 2b.

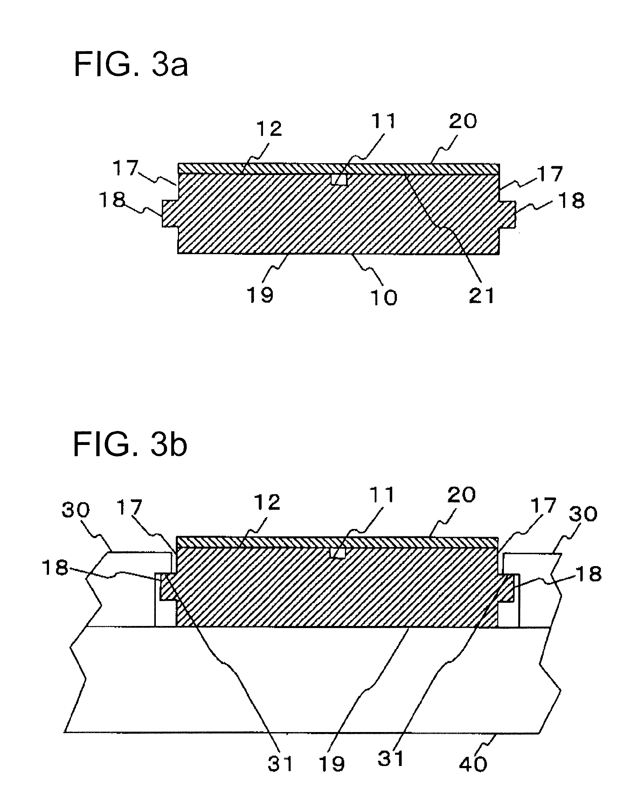

Next, the microchip relating to the other embodiment of the invention will be described with reference to Fig. 3. Fig. 3a is a cross-sectional drawing of the microchip which was cut by a surface perpendicular to the first surface of the microchip, and Fig. 3b is a drawing showing a method for preparing the microchip.

Shown in Fig. 3a is the resin substrate 10, in which the protruding parts 18 are disposed at intermediate locations of the sidewalls 17 of the resin substrate 10 between the first surface 12 and the second surface 19 of the resin substrate 10. The basic constitution is the same as that of the above-mentioned resin substrate 10 of the microchip except that the protruding parts 18 are disposed at intermediate locations of the sidewalls 17 in this embodiment and the protruding parts 18 of the above-mentioned resin substrate 10 of the microchip are disposed at the second surface 19 sides. The protruding parts 18 are disposed over the whole sidewalls 17 constituting the outer peripheral of the resin substrate 10, but may be disposed at a part of the sidewalls 17. The board thickness T of the protruding part 18 is 0.5 mm or more, and is thinner than the board thickness T1 of the resin substrate 10.

Next, a method for preparing the microchip shown in Fig. 3 a will be described with reference to Fig. 3b. The method for preparing the microchip shown in Fig. 3a differs from the above-mentioned method for preparing the microchip shown in Fig. 1a in the step 4, but the other steps (that is, the steps 1 to 3 and 5) are basically the same. In the following, only the step 4 will be described and descriptions on the other steps will be omitted.

In the step 4 of the method for preparing the microchip shown in Fig. 3a, each of a pair of protruding parts 18 facing each other is firmly held down by the jig 30 (being a fixing step). As the jig 30, used is a jig which is formed in a square-like framework by cutting a hole in the center of a stainless steel board, the size of which is greater than that of the first surface 12 of the resin substrate 10. The lower side of the jig 30 is deeply cut out so as not to interfere with the protruding part 18. Close contacting parts 31, which are the ceilings of the cut out concavo portions, are made close contact with a pair of protruding parts 18.

A pair of protruding parts 18, which are firmly held down by the jig 30, may be a pair of protruding parts 18, each of which is disposed at each ofboth sides from and to which the roller advances so that they faces each other, or may be a pair of protruding parts 18, each of which is disposed along the advancing direction of the roller so that they faces each other.

The thickness of the jig 30 is made smaller than the total thickness of the resin substrate 10 and the resin film 20 so that the roller does not interfere with the jig 30. The jig 30 which was disposed at lower position than the position of the resin film 20 which is bonded to the first surfaces 12 of the resin substrate 10 is shown in Fig. 3b.

### (Method for Determining Warp Angle of Microchip)

Next, a method for determining a warp angle of a microchip will be described.

For determining a warp angle of the microchip, used is a high-precision angle measuring device LA-2000 (manufactured by Keyence Corporation) or an equivalent apparatus. The measuring principle is that laser light is irradiated onto an object, and the reflected laser light is focused onto a CCD element, whereby an amount of inclination of the object is converted into an angle. The specific measuring method is as follows: The microchip is fixed to an XY stage with a jig so that an inclination of the central part thereof becomes zero degree. Subsequently, the whole area of the microchip is scanned by moving the XY stage to measure the inclination angle at each point, and the maximum value of the inclination angle is defined as the warp angle of the microchip.

### (Peel-off Test)

Next, a peel-off test of a microchip will be described.

In order to evaluate a bonding force of the resin film to the resin substrate, determination is carried out in accordance with a 90 degree peel-off method stipulated in JIS Z 0237.

Specifically, to secure a margin for peeling-off, a resin film is cut so that only one of four sides of the film is larger than a resin substrate in about 10 mm, and the resin film is thermally bonded to the resin substrate. After that, the resin film of 10 mm in length protruded from the resin substrate is nipped with a jig, which is pulled toward a 90 degree-perpendicular direction, and then a value obtained by dividing a load at which the film is peeled off with a bonding width of the resin film is used as the bonding force. A bonding force of peripheral part of the microchip is an average value when the film was peeled off by 2 mm from the end of the chip, and a bonding force of central part of the microchip is an average value when an area including a central part (being the center of gravity) was peeled off by 2 mm.

### (Materials of Resin Substrate and Resin Film)

Next, materials of the resin substrate 10 and the resin film 20 will be described. As the material for the resin substrate 10, acrylic resin such as polymethyl methacrylate (PMMA) is preferably used. The PMMA used for a material of the resin substrate 10 includes ACRYPET, manufactured by Mitsubishi Rayon Co., Ltd., SUMIPEX, manufactured by Sumitomo Chemical Co., Ltd., DELPET, manufactured by Asahi Kasei Corporation, and PARAPET, manufactured by KURARAY Co., Ltd. The PMMA used for a material of the resin film 20 includes ACRYPLEN, manufactured by Mitsubishi Rayon Co., Ltd., TECHNOLOY, manufactured by Sumitomo Chemical Co., Ltd., and SUNDUREN, manufactured by Kaneka Corporation.

### EXAMPLES

The specific examples and comparative examples will be described below. As the bonding method of the resin substrate 10 and the resin film 20, adopted is the method (2), in which, as described above, the resin film 20 side is made as a roller and the resin substrate 10 side is made as a stage 40, a plane board to hold the resin substrate 10, and the roller is rotated while pressing the stage 40. In the method (2), the warp of the microchip is generated, but wrinkles, mixing-in of air bubbles or deformation of flow path are less likely occurred, compared to the method (1), in which, as described above, rollers are rotated while holding the resin substrate 10 and the resin film 20 from the both sides thereof between the rollers, and the pressing method (3), in which, as described above, the resin substrate 10 and the resin film 20 are pressed by parallel boards from the both sides. Namely, the method (2) can be an effective bonding method, if only the problem of the warp of the microchip can be solved. However, the present invention is not limited to any one of methods (1) to (3).

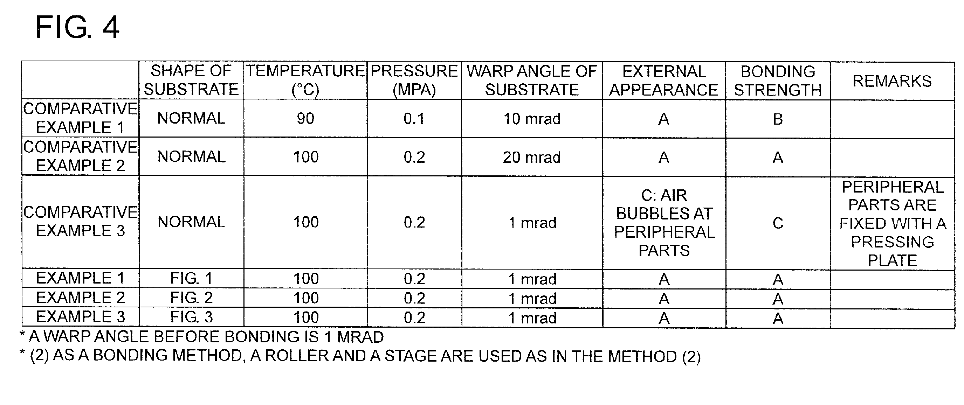

Next, the specific examples and comparative examples will be described with reference to Fig. 4. Fig. 4 is a table showing preparing conditions of the microchip and the evaluation results.

Each example will be described below. Examples 1 to 3 are examples of the microchip made by thermal bonding of the resin film 20 to the resin substrates 10 which were made based on Figs. 1 to 3, respectively.

### (Example 1)

Example 1 will be described below.

### (Bonding of Microchip)

In producing the resin substrate 10, acrylic resin, a transparent resin material, such as polymethyl methacrylate (DELPET 70 NH, manufactured by Asahi Kasei Corp.), is formed by an injection molding machine. With the molding, on a plate-like member having external dimensions of 50 mm × 50 mm × 1 mm, formed are plural flow path grooves 11 of 50 µm in width and 50 µm in depth, and plural through-holes 15 of 2 mm in internal diameter. The resin substrate 10 was formed in a shape as shown in Fig. 1.

In producing the resin film 20, cut into 50 mm × 50 mm pieces was acrylic resin, a transparent resin material, such as polymethyl methacrylate (ACRYPLENE, 75 µm in thickness, manufactured by Mitsubishi Rayon Co., Ltd.).

In the bonding of the resin substrate 10 to the resin film 20, utilizing the protruding part 18 of the resin substrate 10, the resin substrate 10 was covered with the jig 30, which was used for preventing the warp of the microchip. At this process, it was assembled so that the jig 30 did not at all interfere with the first surface 12 of the resin substrate 10. In order to avoid the interference by the jig 30, the shape of the jig 30 was made such that the height of the jig 30 become lower than the total height of the resin substrate 10 and the resin film 20.

Then, a precise positioning was made so that the resin substrate 10 and the resin film 20 were superposed with each other, after which the resin film was combined with the first surface 12 of the resin substrate on which the flow paths 11 were formed, and then, the resin substrate 10 and the resin film 20 were bonded with the temperature of both the stage 40, that is a plane board, and the roller being set at 100 degrees and the pressure being set at 0.2 MPa.

### (Evaluation of Microchip after Bonding)

After the bonding, when the warp angle of the microchip was measured via a high-precision angle measuring device LA-2000, manufactured by Keyence Corporation, it was found to be 1 mrad. Next, when the external appearance of the microchip was inspected using a microscope, no particular problem was found. Further, when the peel-off test was carried out, it was confirmed that the microchip has sufficient bonding strength. From the above results, it was decided that the microchip prepared with this condition can be practically used. The evaluation of the microchip relating to Example 1 was shown in Fig. 4.

### (Example 2)

Example 2 will be described below.

### (Bonding of Microchip)

In producing the resin substrate 10, acrylic resin, a transparent resin material, such as polymethyl methacrylate (DELPET 70 NH, manufactured by Asahi Kasei Corp.), is formed by an injection molding machine. With the molding, on a plate-like member having external dimensions of 50 mm × 50 mm × 1 mm, formed are plural flow path grooves 11 of 50 µm in width and 50 µm in depth, and plural through-holes 15 of 2 mm in internal diameter. The resin substrate 10 was formed in a shape as shown in Fig. 2.

In producing the resin substrate 10, cut into 50 mm × 50 mm pieces was acrylic resin, a transparent resin material, such as polymethyl methacrylate (ACRYPLENE, 75 µm in thickness, manufactured by Mitsubishi Rayon Co., Ltd.).

In the bonding of the resin substrate 10 to the resin film 20, utilizing the protruding part 18 of the resin substrate 10, the resin substrate 10 was covered with the jig 30, which was used for preventing the warp of the microchip. At this process, it was assembled so that the jig 30 did not at all interfere with the first surface 12 of the resin substrate 10. In order to avoid the interference by the jig 30, the shape of the jig 30 was made such that the height of the jig 30 become lower than the total height of the resin substrate 10 and the resin film 20.

Then, the precise positioning was made so that the resin substrate 10 and the resin film 20 were superposed with each other, after which the resin film was combined with the first surface 12 of the resin substrate on which the flow paths 11 were formed, and then, the resin substrate 10 and the resin film 20 were bonded with the temperature of both the stage 40, that is a plane board, and the roller being set at 100 degrees and the pressure being set at 0.2 MPa.

### (Evaluation of Microchip after Bonding)

After the bonding, when the warp angle of the microchip was measured via a high-precision angle measuring device LA-2000, manufactured by Keyence Corporation, it was found to be 1 mrad. Next, when external appearance of the microchip was observed using a microscope, no particular problem was found. Further, when the peel-off test was carried out, it was confirmed that the microchip has sufficient bonding strength. From the above results, it was decided that the microchip prepared with this condition can be practically used. The evaluation of the microchip relating to Example 2 was shown in Fig. 4.

### (Example 3)

Example 3 will be described below.

### (Bonding of Microchip)

In producing the resin substrate 10, acrylic resin, a transparent resin material, such as polymethyl methacrylate (DELPET 70 NH, manufactured by Asahi Kasei Corp.), is formed by an injection molding machine. With the molding, on a plate-like member having external dimensions of 50 mm × 50 mm × 1 mm, formed are plural flow path grooves 11 of 50 µm in width and 50 µm in depth, and plural through-holes 15 of 2 mm in internal diameter. The resin substrate 10 was formed in a shape as shown in Fig. 3.

In producing the resin film 20, cut into 50 mm × 50 mm pieces was acrylic resin that was a transparent resin material, such as polymethyl methacrylate (ACRYPLENE, 75 µm in thickness, manufactured by Mitsubishi Rayon Co., Ltd.).

In the bonding of the resin substrate 10 with the resin film 20, utilizing the protruding part 18 of the resin substrate 10, the resin substrate 10 was covered with the jig 30, which was used for preventing the warp of the microchip. At this process, it was assembled so that the jig 30 did not at all interfere with the first surface 12 of the resin substrate 10. In order to avoid the interference by the jig 30, the shape of the jig 30 was made such that the height of the jig 30 become lower than the total height of the resin substrate 10 and the resin film 20.

Then, the precise positioning was made so that the resin substrate 10 and the resin film 20 were superposed with each other, after which the resin film was combined with the first surface 12 of the resin substrate on which the flow paths 11 were formed, and then, the resin substrate 10 and the resin film 20 were bonded with the temperature of both the stage 40, that is a plane board, and the roller being set at 100 degrees and the pressure being set at 0.2 MPa.

### (Evaluation of Microchip after Bonding)

After the bonding, when the warp angle of the microchip was measured via a high-precision angle measuring device LA-2000, manufactured by Keyence Corporation, it was found to be 1 mrad. Next, when external appearance of the microchip was observed using a microscope, no particular problem was found. Further, when the peel-off test was carried out, it was confirmed that the microchip has sufficient bonding strength. From the above results, it was decided that the microchip prepared with this condition can be practically used. The evaluation of the microchip relating to Example 3 was shown in Fig. 4.

Materials of the microchip and the preparing method thereof which were shown in the above Examples 1 to 3 are just one example, and the present invention is not limited to them.

Next, Comparative Examples will be described below. The following Comparative Examples are examples of a microchip in which the sidewalls 17 of the resin substrate 10 have no inclination, and of a microchip having no protruding part 18.

### (Comparative Example 1)

Comparative Example 1 will be described below.

### (Bonding of Microchip)

In producing the resin substrate 10, acrylic resin, a transparent resin material, such as polymethyl methacrylate (DELPET 70 NH, manufactured by Asahi Kasei Corp.), is formed by an injection molding machine. With the molding, on a plate-like member having external dimensions of 50 mm × 50 mm × 1 mm, formed are plural flow path grooves 11 of 50 µm in width and 50 µm in depth, and plural through-holes 15 of 2 mm in internal diameter. The resin substrate 10 was formed in a shape as shown in Fig. 1.

In producing the resin film 20, cut into 50 mm × 50 mm pieces was acrylic resin that was a transparent resin material, such as polymethyl methacrylate (ACRYPLENE, 75 µm in thickness, manufactured by Mitsubishi Rayon Co., Ltd.).

In the bonding of the resin substrate 10 with the resin film 20, the precise positioning was made so that the resin substrate 10 and the resin film 20 were superposed with each other, after which the resin film was combined with the first surface 12 of the resin substrate on which the flow paths 11 were formed, and then, the resin substrate 10 and the resin film 20 were bonded with the temperature of both the stage 40, that is a plane board, and the roller being set at 90 degrees and the pressure being set at 0.1 MPa.

### (Evaluation of Microchip after Bonding)

After the bonding, when the warp angle of the microchip was measured via a high-precision angle measuring device LA-2000, manufactured by Keyence Corporation, it was found to be 10 mrad. Next, when the external appearance of the microchip was inspected using a microscope, no particular problem was found. Further, when the peel-off test was carried out, it was found that the bonding strength was such a level that the resin film 20 was readily peeled off from an edge of the film. From the above results, it was decided that the microchip prepared with this condition can not be practically used. The evaluation of the microchip relating to Comparative Example 1 was shown in Fig. 4.

### (Comparative Example 2)

Comparative Example 2 will be described below.

### (Bonding of Microchip)

In producing the resin substrate 10, acrylic resin, a transparent resin material, such as polymethyl methacrylate (DELPET 70 NH, manufactured by Asahi Kasei Corp.), is formed by an injection molding machine. With the molding, on a plate-like member having external dimensions of 50 mm × 50 mm × 1 mm, formed are plural flow path grooves 11 of 50 µm in width and 50 µm in depth, and plural through-holes 15 of 2 mm in internal diameter. The resin substrate 10 was formed in a shape as shown in Fig. 1.

In producing the resin film 20, cut into 50 mm × 50 mm pieces was acrylic resin that was a transparent resin material, such as polymethyl methacrylate (ACRYPLENE, 75 µm in thickness, manufactured by Mitsubishi Rayon Co., Ltd.).

In the bonding of the resin substrate 10 with the resin film 20, the precise positioning was made so that the resin substrate 10 and the resin film 20 were superposed with each other, after which the resin film was combined with the first surface 12 of the resin substrate on which the flow paths 11 were formed, and then, the resin substrate 10 and the resin film 20 were bonded with the temperature of both the stage 40, that is a plane board, and the roller being set at 100 degrees and the pressure being set at 0.2 MPa.

### (Evaluation of Microchip after Bonding)

After the bonding, when the warp angle of the microchip was measured via a high-precision angle measuring device LA-2000, manufactured by Keyence Corporation, it was found to be 20 mrad. Next, when the external appearance of the microchip was inspected using a microscope, no particular problem was found. Further, when the peel-off test was carried out, it was confirmed that the microchip has sufficient bonding strength. From the above results, it was decided that the warp angle of the microchip exceeds the tolerance, and thereby the microchip prepared with this condition can not be practically used. The evaluation of the microchip relating to Comparative Example 2 was shown in Fig. 4.

### (Comparative Example 3)

Comparative Example 3 will be described below.

### (Bonding of Microchip Substrate)

In producing the resin substrate 10, acrylic resin, a transparent resin material, such as polymethyl methacrylate (DELPET 70 NH, manufactured by Asahi Kasei Corp.), is formed by an injection molding machine. With the molding, on a plate-like member having external dimensions of 50 mm × 50 mm × 1 mm, formed are plural flow path grooves 11 of 50 µm in width and 50 µm in depth, and plural through-holes 15 of 2 mm in internal diameter. The resin substrate 10 was formed in a shape as shown in Fig. 1.

In producing the resin film 20, cut into 50 mm × 50 mm pieces was acrylic resin, a transparent resin material, such as polymethyl methacrylate (ACRYPLENE, 75 µm in thickness, manufactured by Mitsubishi Rayon Co., Ltd.).

In the bonding of the resin substrate 10 with the resin film 20, the precise positioning was made so that the resin substrate 10 and the resin film 20 were superposed with each other, after which the resin film was combined with the first surface 12 of the resin substrate on which the flow paths 11 were formed.

In order to avoid the warp of the microchip in response to the results of Comparative Examples 1 and 2, prepared was a pressing plate, in which a 49 mm × 49 mm hole was cut in the center of a stainless steel board of 100 µm in thickness, and then the pressing plate was fixed on the superposed microchip so that the microchip was not warped by the heat of the roller and the pressure. The film and the substrate was bonded with the temperature of both the stage 40 and the roller being set at 100 degrees and the pressure being set at 0.2 MPa.

### (Evaluation of Microchip after Bonding)

After the bonding, when the warp angle of the microchip was measured via a high-precision angle measuring device LA-2000, manufactured by Keyence Corporation, it was found to be 1 mrad. Since the warp angle of the resin substrate 10 before it was bonded was 1 mrad, it was found that the warp was avoided. However, when the external appearance of the microchip was inspected using a microscope, it was found that the surrounding area of the microchip was not bonded and air bubbles were mixed in. In addition, when the peel-off test was carried out, the microchip was easily peeled off from the surrounding area thereof From the above results, it was decided that the microchip prepared with this condition can not be practically used. The evaluation of the microchip relating to Comparative Example 3 was shown in Fig. 4.

As stated above, Examples and Comparative Examples were described. In Examples, it was found that the warp of the microchip could be reduced below its tolerance by firmly holding down the sidewall 17 of the resin substrate 10 or the protruding part 18 of the sidewall 17 when the resin substrate 10 and the resin film 20 were thermally bonded by a roller. On the other hand, in Comparative Examples, it was found that the warp of the microchip exceeded its tolerance, when the resin substrate 10 was subjected to thermal bonding without firmly holding down using a jig. Further, in Comparative Examples, it was found that air bubbles were generated when the peripheral part of the resin substrate 10 was firmly held down by the pressing plate.

### DESCRIPTION OF NUMERIC DESIGNATIONS

10: a resin substrate
11: a flow path groove
12: the first surface
121: a periphery
13: an undersurface of flow path groove
14: a surface of wall of flow path groove
15: a through-hole
17: a sidewall
18: a protruding part
19: the second surface
20: a resin film
21: a lower surface
30: a jig
31 and 32: a close contacting part
40: a stage

## Claims

1. A microchip comprising:
a resin substrate provided with a first surface on which flow path grooves are formed and
a second surface which is located on an opposite side of the first surface; and
a resin film bonded to the first surface;
wherein a projected area of the resin substrate, when viewed from a direction perpendicular to the first surface, is larger than the area of the first surface of the resin substrate.

2. The microchip of Claim 1,
wherein the resin substrate has a shape of a frustum in which the area of the second surface is larger than the area of the first surface.

3. The microchip of Claim 1,
further comprising;
a protruding part, which is arranged at a sidewall of the resin substrate between the first and the second surfaces and protrudes outward from the periphery of the first surface; and
the protruding part is arranged at a position of a second surface side of the sidewall.

4. The microchip of Claim 1, further comprising;
a protruding part, which is arranged at the sidewall of the resin substrate at between the first and the second surfaces and protruded outward from the periphery of the first surface; and
the protruding part is arranged at an intermediate location between the first and the second surfaces of the sidewall.

5. The microchip of Claim 3 or 4, wherein a board thickness of the protruding part is 0.5 mm or more, and is thinner than the board thickness of the resin substrate.

6. The microchip in any one of the Claims 3 to 5, wherein the protruding part is formed via an injection molding in an integrated fashion with a body of the resin substrate.

7. A method for manufacturing a microchip having a resin substrate provided with a first surface on which flow path grooves are formed and a second surface which is located on an opposite side of the first surface and having a shape in which a projected area when viewed from a direction perpendicular to the first surface is larger than an area of the first surface, and a resin film bonded to the first surface,
wherein the method comprising the steps of:
fixing a sidewall of the resin substrate using a jig; and
bonding a resin film on a surface of the resin substrate which is fixed with the above jig.

8. The method for manufacturing the microchip of Claim 7,
wherein the resin substrate has a protruding part, which is arranged at a sidewall of the resin substrate at between the first and the second surfaces and protrudes outward from the periphery of the first surface; and
the protruding part is fixed with the jig at the fixing step.

9. The method for manufacturing the microchip of Claim 7 or 8,
wherein, the jig is arranged so as not to be protruded in the direction perpendicular to the first surface than an imaginary plane which is an extension of the first surface, at the fixing step.
